**Europäisches Patentamt**

**European Patent Office**

**Office européen des brevets**

(19)

(11) Veröffentlichungsnummer: **0 028 820**
**A2**

(12) # EUROPÄISCHE PATENTANMELDUNG

(21) Anmeldenummer: **80106875.0**

(22) Anmeldetag: **07.11.80**

(51) Int. Cl.³: **H 01 L 25/04**
**E 06 B 9/24**

(30) Priorität: **13.11.79 CH 1011379**

(43) Veröffentlichungstag der Anmeldung:
**20.05.81 Patentblatt 81 20**

(84) Benannte Vertragsstaaten:
**AT DE FR GB IT**

(71) Anmelder: **Züllig, Harry Teddy**
**Residenza Collin d'Oro Casa A**
**CH-6926 Montagnola(CH)**

(72) Erfinder: **Züllig, Harry Teddy**
**Residenza Collin d'Oro Casa A**
**CH-6926 Montagnola(CH)**

(54) **Verfahren zur Erzeugung elektrischer Energie an Fenstern.**

(57) Bei der vorliegenden Erfindung handelt es sich darum, dass die vertikalen Flächen an Bauten, also die Aussenfassaden, und insbesondere die Fenster zusätzlich zu den bisher bekannten Funktionen benutzt werden für eine Energie-Erzeugung. Die Anordnung zahlreicher Solarzellen erfordert entsprechende Flächen, die heute meist auf den Dächern oder auf freiem Feld aufzuwenden sind. Der Nachteil liegt darin, dass einerseits neue Flächen geopfert werden müssen, zum anderen, dass die Energie-Bilanz beachtlich verschlechtert wird durch zusätzliche Aufwendungen für permanente Reinigung, für mechanischen Schutz und allenfalls für Bewegungs-Vorrichtungen, um die Solarzellen in einen möglichst günstigen Winkel zur direkten Sonneneinstrahlung zu bringen.

Die Fassadenflächen hingegen sind vorhanden und stehen in der Gesamtheit immer teilweise in einem günstigen Winkel zur Sonnenbahn, so dass die darauf angebrachten Solarzellen wenigstens teilweise immer einen optimalen Wirkungsgrad entfalten können. Auch die Fensterkonstruktionen sind vorhanden und können als Träger der Solarzellen benützt werden. Das Wegfallen ganzer Drehkonstruktionen, um beispielsweise auf dem Dach ganze Konstrucktionen bewegen zu können und das Entfallen einer komplizierten zusätzlichen Reinigung verbessert im Sinne der Erfindung die Energie-Bilanz ganz erheblich. Eine weitere Verbesserung ergibt sich dadurch, dass der Minderungsfaktor durch absorbierende Schmutzflächen entfällt. Zudem gibt es heute Bemuhungen, die Fenster lichtaktiv zu gestalten für die Verbesserung der Raumbehaglichkeit und der Raumbeleuchtung mit Tageslicht. Der Gedanke liegt daher nahe, beide Konstruktionsarten zu kombinieren durch den Einbau von geeigneten Solarzellen..Deren Anwendung beschränkt sich jedoch nicht auf die Fenster allein, sondern kann auch die restlichen Fassadenteile einbeziehenals sogenannte Blindfenster resp. als Fassadenmantel.

./...

Fig. 4

Harry T.Züllig,Montagnola,Schweiz.

Verfahren zur Erzeugung elektrischer Energie an Fenstern
durch Solarzellen sowie eine Einrichtung zur Durchführung
dieses Verfahrens.

Die vorliegende Erfindung betrifft ein Verfahren zur Gewinnung
von elektrischer Energie an Fenstern mit Sonnenlichtbestrahlung sowie eine Einrichtung zur Durchführung dieses Verfahrens.

Es ist bekannt,dass Einrichtungen zur Gewinnung von Alternativenergien auf dem Dach von Gebäuden einen relativ geringen Wirkungsgrad aufweisen und somit selten die erhofften
Leistungen bringen. Diese,oft starr angeordneten,Einrichtungen,meist Wärme-Kollektoren oder auch Solarzellentablare,
erreichen die Höchstwerte nur bei bestimmten Neigungswinkel
im Verhältnis zum Azimut und der Sonnenstandshöhe.
Dazu kommt,dass diese Einrichtungen einen starken mechanischen
Schutz benötigen als Schild aus tranparenten Materialien,
meist Glas oder Kunststoff gegen Witterungsschäden,Tierschäden usw.. Die Anlagen sind auch einer sehr starken
Verschmutzung ausgesetzt,besonders in industriellen Ballungsgebieten,welche den Wirkungsgrad erheblich vermindert.Die
erforderlichen Reinigungsarbeiten sind dabei zu aufwendig
und reduzieren den Energie-Saldo weitgehend.
Die Fenster am Bau hingegen sind meist auf leichte Weise
problemlos zu säubern,was ohnehin regelmässig geschieht aus
anderen Gründen.Die Fensterflächen können zudem ein Mehrfaches
derjenigen der Dachfläche erreichen,insbesondere bei modernen Hochbauten für Büros und Labors,so dass schon daraus
vor Fall zu Fall eine wesentliche Erhöhung der Energieproduktion am gleichen Bau resultiert bei äusserst geringen
Wartungskosten.
Dazu kommt im Weiteren,dass die Möglichkeit besteht,die Neigung der Fensterflächen zu ändern und auch damit eine optimale Energie-Produktion zu erzielen.Zudem tritt diese Energie-
Produktion bereits bei Sonnenaufgang ein und dauert bis

Harry T.Züllig

Sonnenuntergang,da im Laufe der Sonnenwanderung jeweils die verschiedenen Gebäudeseiten und damit deren Fenster optimal bestrahlt werden.

Bekannt sind bereits Fenster mit eingebauten Elementen für die diffusierende Sonnenlichteinstrahlung und Reflektion in den Raum zum Zwecke der besseren direkten Ausnützung des Sonnenlichtes für die Raumbeleuchtung und die Raumbehaglichkeit. Diese Fenster arbeiten meist mit Reflektoren verschiedener Konstruktion und From wie beispielsweise mit Hohlspiegeln oder ähnlichem.

Der Erfindungsgedanke basiert nun darauf,die Fenster gleichzeitg oder auch nur zu dem Zweck auszurüsten für die Erzeugung von Energie mittels Einbau energieproduzierender Solarzellen. Dadurch soll erreicht werden,dass das Fenster die erforderliche Transparenz behält,anderseits die Lichtumlenkung kaum beeinträchtigt wird und gleichzeitig wertvolle Alternativenergie erzeugt werden kann.

Solarzellen sind bis jetzt bekannt als flache Scheiben.Sie erreichen das Optimum der Energieproduktion bei lotrechter Bestrahlung.Es versteht sich,dass eine Vergrösserung der Oberfläche ein Ansteigen der Leistung bedeutet.Die für eine Licht-Umlenkung erforderliche Oberflächen-Deformation bedeutet beispielsweise tatsächlich eine Oberflächen-Vergrösserung,wenn auch bedingt aus anderen Gründen.Wird somit das Reflektionselement als Solarzelle ausgebildet,so sind die Bedingungen erfüllt für ein energie-produzierendes Fenster im Sinne der Erfindung.Dabei kann durch eine einfache mechanische Vorrichtung die Stellung der Solarzellenreihen resp.der Neigungswinkel verändert werden. Dies ist dann von Bedeutung,wenn das Fenster selbst nicht verstellt werden kann oder die Räume hinter den Fenstern nicht genutzt werden an Feiertagen,Ferientagen etc.

Es versteht sich,dass auch sogenannte Blindfenster mit Solarzellen ausgestattet werden können im Sinne der Erfindung,wenn diese beispielsweise an den übrigen Fassadenflächen angebracht sind und die Durchsicht nicht benötigt wird.Damit wäre das energiesparende Flächenteil ein Teil der Fassadenverkleidung.

Harry T.Züllig

In den Figuren der beiliegenden Zeichnung sind Ausführungsbeispiele des Erfindungsgedankens veranschaulicht.

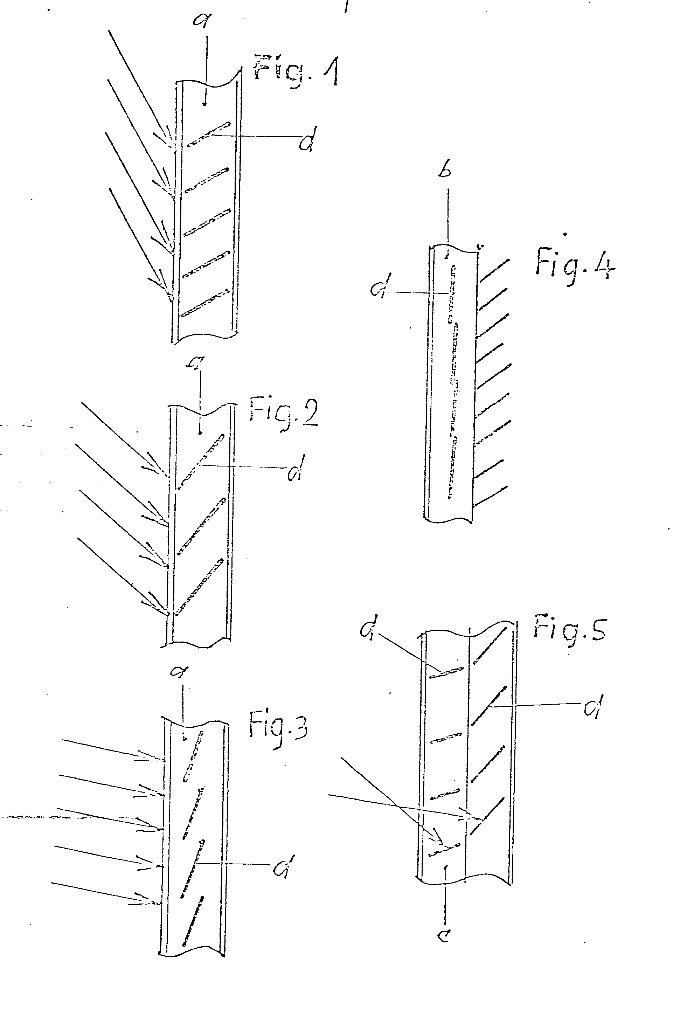

Figur 1 zeigt ein doppelseitig verglastes Fenster a.) üblicher
Konstruktion mit eingebauten Solarzellen d.) bei einem
Sonnen-Einstrahlungswinkel von 60°
Figur 2 zeigt die gleiche Fensterkonstruktion a.) bei einem
Einstrahlungswinkel von 40° und Figur 3 das gleiche Fenster
bei einem Einstrahlungswinkel von 10°
Figur 4 zeigt den Schnitt durchein einseitig verglastes
Fenster b.),worin die Solarzellen d.) fast vertikal eingebaut sind.Vorteilhaft ist hier bei fixer Installation ein
Neigungswinkel der Solarzellen,der ausgerichtet ist auf den
Azimut der Fläche und der Umgebungsverbauung.
Figur 5 zeigt einen Schnitt durch ein Spezialfenster c.)
mit doppelseitiger Verglasung und hintereinander angeordneten Reihen von Solarzellen d.) mit verschiedenen Neigungswinkeln.

0028820

Harry T. Züllig

PATENTANSPRUCH

1.) Verfahren zur Erzeugung elektrischer Energie an Fenstern durch Einbau geeigneter Solarzellen sowie eine Einrichtung zur Durchführung dieses Verfahrens, dadurch gekennzeichnet, dass im Hohlraum verglaster Flächen als Fenster oder Fassadenteile Solarzellen eingebaut sind, die geeignet sind, das einfallende Tageslicht zum Teil oder ganz umzuwandeln in elektrische Energie.

2.) Einrichtung nach Patentanspruch, dadurch gekennzeichnet, dass die Solarzellen kombinierbar sind mit Licht-Umlenkelementen.

3.) Einrichtung nach Patentanspruch, dadurch gekennzeichnet, dass die Solarzellenstellung mechanisch veränderbar ist.

4.) Einrichtung nach Patentanspruch, dadurch gekennzeichnet, dass die Solarzellen eine deformierte Oberfläche aufweisen.

5.) Einrichtung nach Patentanspruch, dadurch gekennzeichnet, dass die Solarzellen in Reihen übereinander angeordnet sind.

6.) Einrichtung nach Patentanspruch, dadurch gekennzeichnet, dass die Solarzellen hintereinander angeordnet sind.

7.) Einrichtung nach Patentanspruch, dadurch gekennzeichnet, dass die Solarzellen innerhalb der Einbaukonstruktion des Fensters elektronisch im Neigungswinkel verändert werden.

Fig. 1

Fig. 2

Fig. 3

Fig. 4

Fig. 5